Europäisches Patentamt

European Patent Office

Office européen des brevets

(19)

(11) **EP 1 187 389 A2**

(12) **EUROPÄISCHE PATENTANMELDUNG**

(43) Veröffentlichungstag:
**13.03.2002  Patentblatt 2002/11**

(51) Int Cl.7: **H04L 7/033**, H04J 3/04

(21) Anmeldenummer: **01119545.0**

(22) Anmeldetag: **14.08.2001**

(84) Benannte Vertragsstaaten:
**AT BE CH CY DE DK ES FI FR GB GR IE IT LI LU MC NL PT SE TR**
Benannte Erstreckungsstaaten:
**AL LT LV MK RO SI**

(30) Priorität: **28.08.2000  DE 10042233**

(71) Anmelder: **SIEMENS AKTIENGESELLSCHAFT**
**80333 München (DE)**

(72) Erfinder:
• **Müllner, Ernst, Dr.**
  **80992 München (DE)**
• **Weiske, Claus-Jörg**
  **82256 Fürstenfeldbruck (DE)**

(54) **Takt- und Datenregenerator mit Demultiplexerfunktion**

(57)    Der Takt- und Phasengenerator arbeitet mit vier Abtastkippstufen (FF1, FF2, FF3, FF4) deren Ausgangssignale mit Hilfe von zwei paaren von EXOR-Elementen PD1, PD2", PD3, PD4) miteinander vergliechen werden. Die von den EXOR-Elementen erzeugten zusammengehörigen Phasensignale PS1, PS3, PS4) werden addiert und miteinander verglichen. Die so gewonnene Phasenregelspannung steuert einen Osilator (VCO), der die Abtasttaktsignale (TS1, TS3, $\overline{TS1}$, $\overline{TS3}$) erzeugt.

**FIG 1**

**Beschreibung**

Die Erfindung betrifft einen Takt- und Datenregenerator mit Demultiplexerfunktion nach dem Oberbegriff des Patentanspruchs 1.

Takt- und Datenregeneratoren für hohe Datenraten werden häufig mit einer Demultiplexerfunktion kombiniert, die das Datensignal in zumindest zwei Datensignale mit der halben Datenrate aufteilt, die dann einem als Phasendektor folgenden EXOR-Element zugeführt werden.

Aus IEEE Journal of Solid State Circuit Volume 34, Nr. 9, September 1999, Seiten 1320-1324 ist ein solcher Phasendedektor beschrieben, der eine dritte Abtastkippstufe aufweist, die von einem phasenverschobenen Taktsignal getaktet wird.

In der Patentschrift DE 19717586 C1 ist ebenfalls dieses Prinzip verwendet, jedoch werden zwei EXOR-Elemente verwendet, um eine Vergleichsspannung zu erzeugen und so Laufzeitveränderungen durch Temperaturunterschiede zu kompensieren.

Wegen der um 180° gegeneinander phasenverschobenen Abtastsignale werden in einer ersten Abtastkippstufe alle geradzahligen und in einer zweiten Abtastkippstufe alle ungeradzahligen Bits des Datensignals übernommen. Eine dritte Abtastkippstufe, hier als Referenz-Abtastkippstufe bezeichnet, wird mit einem um 90° verzögerten Taktsignal, also in der zeitlichen Mitte zwischen den anderen Taktsignalen, abgetastet, und liefert damit ein Ausgangssignal, das bei optimaler Abtastung mit den Ausgangssignalen der anderen Abtastkippstufen unkorreliert ist. Weicht die Taktphase dagegen vom Sollwert ab, ist das Ausgangssignal dieser Kippstufe mit dem Ausgangssignal einer der anderen Abtastkippstufen korreliert, was zu einem entsprechenden Ausgangssignal der als Korrelatoren wirkenden EXOR-Elemente führt. Nach Filterung wird das Signal zur Korrektur der Taktphase eines spannunggesteuerten Osilators verwendet.

Einer prinzipielle Eigenschaft dieser Anordnung ist es, dass wegen der Abtastung mit der halben Datenrate nur jeder zweite Zustandswechsel im Eingangsignal für die Korrelationsfunktion ausgewertet wird, nämlich beispielsweise der Übergang von ungeradzahligen zu geradzahligen Bits. Ist das Eingangssignal so gestaltet, dass zum Zeitpunkt der Abtastung durch die dritte Abtastkippstufe über längere Zeit paarweise kein Zustandswechsel stattfindet, wie beispielsweise bei einem Datensignal "00110011", so tritt kein Differenzsignal zwischen den Ausgängen der EXOR-Elementen auf. Dieser Zustand bleibt erhalten bis sich entweder das Datensignal ändert oder aber sich die Phase des dritten Taktsignal soweit verschoben hat, das wieder Zustandswechsel auftreten. Dann aber sind die Ausgangsdatensignale vertauscht und es treten Bitfehler bis zu einer Neusynchronisation auf.

Aufgabe der Erfindung ist es daher, einen Takt- und Datenregenerator mit Demultiplexer anzugeben, der bei jeder Änderungen eines Datensignals eine Phaseregelspannung erzeugt.

Diese Aufgabe wird durch einen Takt- und Datenregenerator nach Anspruch 1 gelöst.

Der besondere Vorteil der Erfindung liegt in der Auswertung sämtlicher Zustandswechsler des Datensignals. Deshalb wird eine Phasenregelspannung erzeugt, sobald Änderungen im Datensignal auftreten.

Eine vorteilhafte Weiterbildungen sind in den Unteransprüchen angegeben.

Natürlich können zahlreiche Schaltungsvariationen eingesetzt werden. So ist es beispielsweise möglich, die Ausgangssignale jedes EXOR-Elementepaares voneinander zu subtrahieren und dann die Ergebnisse zu vergleichen. Auch können Boolsche Umformungen einschließlich der Invertierung von Eingangssignalen sowie die Verwendung von EXNOR- statt EXOR-Gattern usw. vorgenommen werden. Auch kann die Schaltung für spezielle Codearten (CMI-Code) variiert werden und Phasenregelsignale für eine bestimmte Änderung des Datensignals oder Bitkombinationen unterdrückt werden.

Durch weitere Abtastkippstufen und Referenz-Abtastkippstufen kann die Schaltung zum Demultiplexen in vier oder mehr parallele Datenströme erweitert werden.

Ein Ausführungsbeispiel der Erfindung wird anhand von Figuren näher erläutert.

Es zeigen

Figur 1 ein Ausführungsbeispiel des Takt- und Datengenerators und

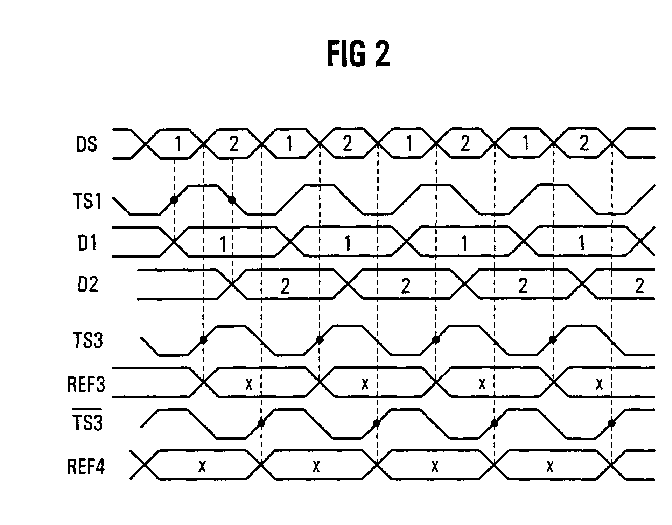

Figur 2 ein zugehöriges Zeitdiagramm.

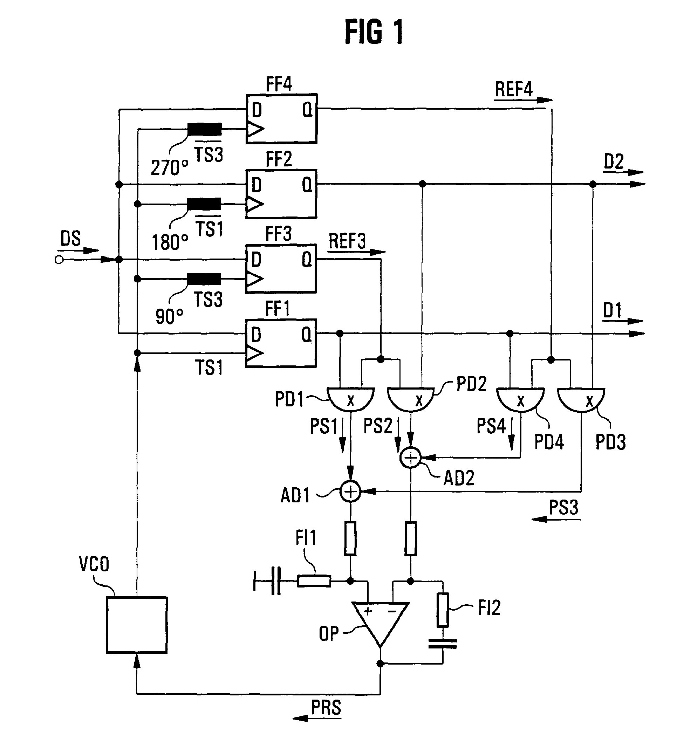

In **Figur 1** ist ein erfindungsgemäßer Takt- und Datengenerator dargestellt. Er enthält vier Abtastkippstufen FF1 bis FF4. zugeführt. Dieses Datensignal wird von 4 gegeneinander phasenverschobenen Taktsignalen TS1, $\overline{TS1}$, TS3 und $\overline{TS3}$ abgetastet. Eine Periode dieser Taktsignal umfaßt zwei Bits des Datensignals. Die wirksamen Flanken der Taktsignale TS1 und $\overline{TS1}$ sind um 180° phasenverschoben. Gegenüber dem Taktsignal TS1 ist das Taksignal TS3 um 90° verschoben. Ebenso ist das Taktsignal $\overline{TS3}$ gegenüber Taktsignal TS3 um 180° und das Taktsignal $\overline{TS3}$ gegenüber dem Taktsignal $\overline{TS1}$ um 90° verschoben.

Im eingerasteten Zustand des Taktregenerators werden die Bits des Datensignals DS von den Taktsignalen TS1 und $\overline{TS1}$ in der Mitte abgetastet, in die Abtastkippstufen FF1 und FF2 übernommen und in zwei Datensignale D1 und D2 zerlegt, die ihrerseits auch wiederum zwei oder mehr nach dem Zeitmultiplexverfahren miteinander verschachtelte Datensignale enthalten können. Zusätzlich wird das Datensignal mit den Taktsignalen TS3 und $\overline{TS3}$ abgetastet, deren wirksame Flanken mit den Flanken des Datensignals zusammenfallen. Die aggetasteten Bits werden in die Referenz-Abtastkippstufen FF3 und FF4 übernommen.

In an sich bekannter Weise werden durch EXOR-Elemente, hier EXNOR-Gatter PD1, PD2, PD3 und PD4 vier Phasensignale PS1 und PS2 sowie PS3 und PS4 erzeugt. Entsprechende Phasensignale PS1 und PS3 sowie PS2 und PS4 werden in einem ersten Addierer AD1 und die Phasensignale PS2 und PS4 in einem zweiten Addierer AD2 addiert und dann in einer Vergleichsschaltung, einem Operationsverstärker OP, miteinander verglichen. Der Operationsverstärker ist gleichzeitig als Tiefpassfilter ausgebildet, so dass eine gefilterte Phasenregelspannung PRS von der Vergleichsschaltung abgegeben wird und einen Osilator VCO steuert, der das Abtasttaktsignal TS1 abgibt. Die Verschiebung der Taktsignale gegeneinander wird in der Regel nicht, wie symbolisch dargestellt, durch Laufzeitglieder erreicht werden, sondern durch Invertieren von Taktsignalen.

**Patentansprüche**

1. Takt- und Datenregenerator mit einer ersten, zweiten und dritten Abtastkippstufe (FF1, FF2, FF3), deren Dateneingängen (D) ein Datensignal (DS) zugeführt wird, wobei der ersten Abtastkippstufe (FF1) ein erstes Taktsignal (TS1) zugeführt wird, dessen Taktperiode der Dauer von zwei Bits des Datensignals (DS) entspricht, der zweiten Abtastkippstufe (FF2) ein hierzu um 180° phasenverschobenes zweites Taktsignal ($\overline{TS1}$) zugeführt wird und der dritten Abtastkippstufe (FF3), einer Referenzabtastkippstufe, ein um 90° gegenüber einem dieser Taktsignale verschobenes drittes Taktsignal ($\overline{TS3}$) zugeführt wird, mit einem ersten und einem zweiten EXOR-Element (PD1, PD2), deren erste Eingänge mit jeweils einem Ausgang der ersten und zweiten Abtastkippstufe (FF1, FF2) und deren zweite Eingänge mit einem Ausgang der dritten Abtastkippstufe (FF3) verbunden sind, mit einem Vergleichselement (OP), dessen Eingängen die Ausgangssignale der EXOR-Elemente (EXOR1, EXOR2) zugeführt werden und mit einem Oszillator (VCO), dessen Frequenz von einem gefilterten Ausgangssignal (PRS) des Vergleichelementes (OP) gesteuert wird **dadurch gekennzeichnet,**

   **dass** eine vierte Abtastkippstufe (FF4) als weitere Referenz-Abtastkippstufe vorgesehen ist, der ebenfalls das Datensignal (DS) und ein um 180° gegenüber dem dritten Taktsignal phasenverschobenes viertes Taktsignal ($\overline{TS3}$) zugeführt sind,
   **dass** ein drittes EXOR-Element (PD3) und ein viertes EXOR-Element (PD4) vorgesehen sind, deren erste Eingänge ebenfalls mit jeweils einem Ausgang der ersten und zweiten Abtastkippstufe (FF1, FF2) verbunden sind und deren zweite Eingänge mit einem Ausgang der vierten Abtastkippstufe (FF4) verbunden sind, und dass eine Additions- und Vergleichsschaltung ((AD1, AD2, OP) vorgesehen ist, die einander entsprechende Ausgangssignale (PS1, PS3; PS2, PS4) des ersten und des dritten EXOR-Elements (PD1, PD2) sowie des zweiten und des vierten EXOR-Elements (PD2, PD4) zusammenfaßt und vergleicht, und dass eine so gewonnenes und gefiltertes Phasenregelsignal (PRS) den Oszillators (VCO) steuert.

2. Takt- und Datenregenerator nach Anspruch 1, **dadurch gekennzeichnet,** **dass** die Ausgangssignale (PS1, PS3) des ersten und dritten EXOR-Elements (PD1, PD3) sowie des zweiten und des vierten EXOR-Elements (PD2, PD4) jeweils in einem Addierer (AD1, AD2) zusammengefaßt wurden und dass die so gewonnenen Summensignale einer Vergleichsschaltung (OP) zugeführt werden.

3. Takt- und Datenregenerator nach Anspruch 2, **dadurch gekennzeichnet,** **dass** als Vergleichsschaltung ein Subtrahierer (OP) vorgesehen ist ,der als Tiefpaßfilter ausgebildet ist.

4. Takt- und Datenregenerantor nach Anspruch 1, **dadurch gekennzeichnet,** **dass** noch zwei weitere Abtaststufen und noch zwei weitere Referenz-Abtaststufen vorgesehen sind, die mit jeweils um 45° verschobene Taktsignale getaktet werden, wobei die Periodendauer der Taktsignale der Dauer von vier Bits des Datensignals (DS) entspricht, und dass vier Paare von EXOR-Elementen und eine Additions- und Vergleichsschaltung vorgesehen ist, die die entsprechenden Phasensignale der EXOR-Elemente addiert und die Summensignale miteinander vergleicht.

# FIG 1

# FIG 2